(19) Europäisches Patentamt
European Patent Office
Office européen des brevets

(11) Veröffentlichungsnummer : **0 109 920**
**B1**

(12) # EUROPÄISCHE PATENTSCHRIFT

(45) Veröffentlichungstag der Patentschrift : **01.02.89**

(51) Int. Cl.⁴ : **H 05 K 3/42**, H 05 K 3/00, C 23 C 18/18

(21) Anmeldenummer : **83730109.2**

(22) Anmeldetag : **11.11.83**

(54) **Verfahren zum Reinigen von Löchern in gedruckten Schaltungsplatten mit permanganathaltigen und basischen Lösungen.**

(30) Priorität : **19.11.82 US 443160**

(43) Veröffentlichungstag der Anmeldung : **30.05.84 Patentblatt 84/22**

(45) Bekanntmachung des Hinweises auf die Patenterteilung : **01.02.89 Patentblatt 89/05**

(84) Benannte Vertragsstaaten : **AT DE IT NL SE**

(56) Entgegenhaltungen :
**DE-A- 2 239 908**
**US-A- 4 042 729**

(73) Patentinhaber : **KOLLMORGEN CORPORATION**
**10 Mill Pond Lane**
**Simsbury, CT 06070 (US)**

(72) Erfinder : **Nuzzi, Francis J.**
**308 Locust Avenue**
**Freeport, L.I., NY 11250 (US)**
Erfinder : **Duffy, John K.**
**244-01 61st Avenue**
**Douglastown, NY 11362 (US)**

(74) Vertreter : **Meinig, Karl-Heinz, Dipl.-Phys. et al**
**Patentanwälte Pfenning, Meinig, Butenschön, Bergmann, Nöth Mozartstrasse 17**
**D-8000 München 2 (DE)**

**EP 0 109 920 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die vorliegende Erfindung betrifft ein Verfahren zur Vorbereitung der Kunstharzhaltigen Oberfläche eines Werkstücks für die nachfolgende Metallisierung gemäß dem Oberbegriff des Anspruchs 1.

Bei der Herstellung von Lochungen in kunstharzhaltigen Werkstoffen treten häufig Harzverschmierungen an den Lochwänden auf, insbesondere wegen der beim Bohrvorgang auftretenden bzw. verwendeten Temperaturen, die oberhalb des Schmelzpunktes des Kunstharzes liegen. So steigt z. B. beim Bohren von Löchern in Epoxy-beschichteten Glasfaserlaminaten die Temperatur des Bohrers auf 260 °C bis 315 °C an, was oberhalb des Schmelzpunktes der meisten Kunstharzgemische liegt. Es sammelt sich daher während des Bohrvorganges geschmolzenes Kunstharz an der Bohrerspitze an und wird über die Lochwand verschmiert. Eine ähnliche Harzverschmierung tritt bei der Verwendung von Lasern zur Herstellung von Verbindungen zwischen Leitern im Inneren organischer Isolierstoffe an den freigelegten Leiterorberflächen auf.

Bei einigen Anwendungsbereichen sind derartige Harzverschmierungen ohne störenden Einfluß ; bei anderen ist es jedoch von größter Wichtigkeit, sie zu entfernen, wie beispielsweise bei der Herstellung von Mehrebenenschaltungen, d. h., Schaltungsplatten, die in ihrem Inneren eine Reihe paralleler Leiterzugebenen aufweisen, die durch senkrecht zu diesen angebrachte Löcher in vorbestimmten Punkten miteinander verbunden sind. Zur Herstellung einer leitenden Verbindung zwischen zwei oder mehr Leiterzügen werden in bekannter Weise die Lochwandungen mit Metall beschichtet ; eine leitende Verbindung kommt aber nur dann zustande, wenn zuvor die Harzverschmierungen von den Teilen der Lochwand entfernt wurden, deren metallische Oberflächen durch das Durchtrennen der Leiterzüge gebildet werden.

Die Herstellung leitender Verbindungen vermittels Bohrungen oder gestanzter Löcher mit metallisierten Lochwandungen wird sowohl bei Mehrebenen-Schaltungen als auch bei zweiseitig mit Leiterzügen versehenen Platten vielfach angewendet. Voraussetzung für die erfolgreiche Durchführung dieses Verfahrens ist jedoch, daß die Lochwandmetallisierung frei von mechanischen und elektrischen Defekten ist. Hierzu ist es erforderlich, jegliche Art von Verunreinigungen, wie z. B. Harzverschmierungen und — rückstände vor der Lochwand — metallisierung restlos zu entfernen. Dies betrifft vor allem auch die Teile der Lochwand, die durch die metallischen Stirnflächen von durchtrennten Leiterdrähten gebildet werden.

Die Verbindung von zwei oder mehreren Schaltungsebenen durch Löcher mit metallisierten Wandungen wird ebenfalls bei automatisch verlegten Drahtschaltungen, den sogenannten MULTIWI-RE$^{RTM}$-Schaltungen angewendet. Nach diesem Verfahren werden Leiterzüge aus Draht auf oder in der Plattenoberfläche verlegt, und die leitenden Verbindungen zwischen zwei oder mehreren Ebenen dieser Drahtschaltungen werden durch Löcher mit metallisierten Wandungen hergestellt. Die Löcher werden in den als Verbindungspositionen bestimmten Punkten angebracht und durchtrennen die Drähte der Leiterzüge, so daß die Stirnflächen des Drahtes einen Teil der Lochinnenwand bilden. Als Folge des Bohrvorganges treten auf den Lochwandungen — auch in den Teilen, die durch die Stirnflächen der durchtrennten Leiterzugdrähte gebildet werden — Harzverschmierungen auf, die vor dem anschließenden Metallisierungsvorgang rückstandslos entfernt werden müssen, da sonst kein elektrischer Kontakt zustande kommt bzw. dieser mangelhaft ist. Es besteht auch die Gefahr, daß der Kontakt zunächst zwar ausreichend ist, daß aber durch die Erwärmung bei einem nachfolgenden Lötvorgang die noch vorhandenen Harzreste sich ausdehnen und damit den elektrischen Kontakt vollkommen zerstören.

Es gibt eine Vielzahl von bekannten Verfahren zum Entfernen von Harzverschmierungen und — rückständen, wie z. B. auf mechanischem Weg, bei dem ein Strahl trockenen oder feuchten Schleifmittels durch das Loch geleitet oder ein Schleifmittelbrei hydraulisch durch das Loch gepreßt wird. Nachteile solcher mechanischer Verfahren sind ihre Langwierigkeit und die Schwierigkeiten, die bei der Überwachung sowie bei der Gewährleistung einer gleichmäßigen Entfernung der Verschmierungen und Reinigungaller Löcher einer beliebigen Platte auftreten.

In anderen Verfahren werden harzlösende Chemikalien zum Entfernen der Harzrückstände und -verschmierungen verwendet, wie z. B. konz. Schwefelsäure, mit der eine Harzschicht von 0,025 mm Stärke, wie sie für gewöhnlich maximal auftritt, binnen einer Minute entfernt werden kann. Die Verwendung konz. Schwefelsäure (92 bis 98 %) erfordert jedoch außerordentliche Vorsichtmaßnahmen seitens des Bedienungspersonals und führt zusätzlich zu einer unerwünschten Aufrauhung der Lochinnenwände. Ein weiterer Nachteil besteht darin, daß konz. Schwefelsäure stark hygroskopisch ist, so daß sich die erforderliche Einwirkungsdauer mit der Zeit in Folge von Wasseraufnahme ändert und die Säure schließlich unwirksam wird und ersetzt werden muß.

Es kann auch konzentrierte Chromsäure zum Entfernen von Harzrückständen und -verschmierungen verwendet werden, wobei eine Einwirkungszeit von 5 bis 15 Minuten erforderlich ist. Auch bei der Anwendung dieses Verfahrens muß das Bedienungspersonal besondere Vorsichtsmaßnahmen beachten. Außerdem ist eine besondere Auskleidung sowohl der Tauchbehälter für die Chromsäure als auch der Ummantelung der Plattenhalterungen notwendig. Zunehmend strenge Abwasserauflagen und die Schwierigkeit, Chromsäurerückstände auf ökologisch unbedenklichem Wege zu vernichten, sind weitere Gesichtspunkte, die gegen dieses Verfahren sprechen. Zudem wirken sich Chromrückstände auf den behandelten Oberflächen negativ auf die stromlose Metallabscheidung auf diesen aus. Zur Beseitigung

von Harzverschmierungen und -rückständen in mechanisch oder durch Laser hergestellten Löchern wird auch die Verwendung von Permanganat-Lösungen vorgeschlagen (DE-PS-2 550 598). Dort wird eine alkalische Permanganat-Lösung mit einem pH Wert von mindestens 13 verwendet. Solche Permanganat-Lösungen werden bei der Herstellung von Multiwire$^{RTM}$-Schaltungsplatten verwendet, um verschmiertes Epoxyharz von den Drahtspitzen zu entfernen und die Polyimidisolierung von den Drahtenden abzuätzen. Als Folge dieser Behandlung ergab die anschließende stromlose Metallabscheidung jedoch keine gleichmäßigen Metallschichten, sondern es traten Punktlöcher und unbeschichtete Stellen auf.

In US-4 042 729 sowie DE-2 550 597 wird beschrieben, daß bei der Verwendung von Permanganat-Lösungen mit einem pH Wert zwischen 11 und 13 die auf dem harzhaltigen Basismaterial abgeschiedene Metallschicht eine gute Haftfestigkeit aufweist. In den genannten pH Wert-Bereichen wird jedoch die Polyimid-Isolierschicht der beim Multiwire$^{RTM}$-Verfahren verwendeten Drähte nicht abgeätzt.

Im Multiwire$^{RTM}$-Verfahren sollen durch die Behandlung mit einer Permanganat-Lösung nicht nur die vom Bohren der Löcher herrührenden Harzrückstände entfernt werden ; es soll auch die Polyimid-Isolierung der Drähte von den Schnittstellen, die einen Teil der Lochinnenwände bilden, abgeätzt werden. Nach diesem Schritt erfolgt eine Neutralisationsbehandlung mit $SnCl_2$-, Formaldehyd- oder Hydrazinhydrat-Lösungen und ein Spülen der Löcher. Durch die Permanganat-Behandlung wird die Aktivität des bereits zuvor für die stromlose Metallabscheidung katalytisch aktivierten Basismaterials wesentlich herabgesetzt, so daß bei der anschließenden stromlosen Verkupferung nacheinander zwei verschiedene Metallabscheidungsbäder verwendet werden müssen : Zunächst wird ein Verkupferungsbad eingesetzt, das eine ausreichend hohe Aktivität aufweist, um die Abscheidung einer ersten Kupferschicht zu bewirken ; anschließend wird ein Bad mit veränderter Zusammensetzung verwendet, das weniger aktiv und ausreichend stabil ist, um eine Abscheidungsschicht gewünschter Dicke und Qualität zu erhalten. Die Ausbildung der ersten Abscheidungsschicht erfolgt langsam, wobei sich die erforderliche Zeit nicht im voraus abschätzen läßt. Der Wechsel vom einen zum anderen Abscheidungsbad wird im Allgemeinen auf Grund des Aussehens der ersten Metallschicht vorgenommen, was häufig zu Schwierigkeiten bei der Kontrolle des Badbetriebes führt. Die beiden Abscheidungsbäder können auch nicht kontinuierlich betrieben werden.

Mehrebenenschaltungen werden üblicherweise nach bekannten Verfahren hergestellt, bei denen die Lochwandungen für die stromlose Metallabscheidung mittels katalytisch wirksamer Aktivierungslösungen sensibilisiert werden. Auch hier treten bei der Verwendung von Permanaganat-Lösungen mit hohem pH Wert zur Lochreinigung Punktlöcher und unbeschichtete Bereiche in den stromlos abgeschiedenen Metallschichten auf. Um solche Fehlstellen zu vermeiden, müssen die Platten erneut sensibilisiert werden oder es müssen sogar alle Schritte der stromlosen Verkupferung wiederholt werden. Wird im Anschluß an die Permanganatbehandlung nicht neutralisiert, so bleibt auf der Oberfläche des Basismaterials ein hoachaktiver Permanganatrückstand, der ein Ausfallen von Kupferteilchen aus dem stromlosen Kupferabscheidungsbad und schließlich die Zerstörung des Bades zur Folge hat.

Aufgabe der vorliegenden Erfindung ist es ein verbessertes Verfahren zur Vorbereitung der Kunstharzhaltigen Oberflächen zum Entfernen von Harzrückständen und -verschmierungen auf deren Lochwandungen und eine Verbesserung der Haftfestigkeit auf kunstharzhaltigen Oberflächen vorzugeben ohne daß unerwünschte Rückstände auf der Oberfläche verbleiben.

Damit soll ein rationelleres und leichter steuerbares Verfahren zur Kupferabscheidung auf Basismaterialien, wie sie zur Herstellung von Multiwire$^{RTM}$- und Mehrebenen-Schaltungen verwendet werden ermöglicht werden.

Das Verfahren zur Herstellung von Multiwire$^{RTM}$- oder Mehrebenen-Schaltungen, soll insbesondere so verbessert werden, daß sich die Zuverlässigkeit des Metallabscheidungsvorganges erhöht und ein ununterbrochener Betrieb des Abscheidungsbades erreicht wird, sowie die Entfernung von Harzrückständen und -verschmierungen an Lochwänden in kunstharzhaltigen Materialien erleichtert wird, bei gleichzeitiger Verbesserung der Haftfestigkeit von stromlos abgeschiedenen Metallschichten auf den äußeren Oberflächen des Basismaterials. Diese Aufgaben werden bei einer bevorzugten Verfahrensweise laut geltende Ansprüche erfindungsgemäß gelöst, durch die folgenden Schritte : Behandeln der Oberfläche mit einer alkalischen Permanganat-Lösung deren pH auf einen Wert zwischen 11 und 13 eingestellt ist für eine Zeitspanne, die ausreicht, um eine für auf der genannten Oberfläche abzuscheidende Metallschicht ausreichende Haftfestigkeit zu gewährleisten ; Behandeln der Oberfläche mit einer Lösung einer durch Permanganat oxidierbaren wasserlöslichen Verbindung für eine Zeitspanne, die ausreicht, um alle Manganrückstände zu reduzieren und sie in eine niedrige Oxidationsstufe zu überführen.

Das erfindungsgemäße Verfahren ist dadurch gekennzeichnet, daß die Oberfläche mit einer alkalischen Lösung bei einer Temperatur zwischen 30 °C und 95 °C und für eine Zeitspanne, die ausreicht, um alle Manganrückstände zu entfernen, behandelt wird.

Die vorliegende Erfindung beruht auf der Feststellung, daß ein Zusammenhang zwischen manganhaltigen Rückständen auf der Oberfläche des Basismaterials und der Qualität der anschließend abgeschiedenen Metallschicht besteht.

Zur Bestimmung manganhaltiger Rückstände kann die Oberfläche des Basismaterials mit Königswasser extrahiert und der Extrakt anschließend durch Atomabsorptions-Spektroskopie (AAS) untersucht werden. Große Mengen manganhaltiger Rückstände fanden sich bei der Verwendung basischer

Permanganat-Lösungen mit einem pH von mehr als 13. Alle angegebenen pH Werte wurden bei 25 °C bestimmt. Wurden diese Rückstände nicht neutralisiert, so verlief eine anschließende Metallabscheidung rasch, aber unter spontaner Zersetzung des Abscheidungsbades. Das Zwischenschalten eines Neutralisationsschrittes hatte zur Folge, daß sich wegen der auf der Oberfläche verbleibenden Rückstände Löcher in der anschließend stromlos abgeschiedenen Metallschicht bildeten.

Wird eine alkalische Permanganat-Lösung mit einem pH Wert zwischen 11 und 13 verwendet, verbleibt weniger manganhaltiger Rückstand auf den behandelten Oberflächen einschließlich der Lochwandungen und die Zahl der Löcher in der stromlos abgeschiedenen Metallschicht verringert sich, sie treten jedoch nach wie vor auf.

Durch die anschließende-Behandlung mit einer Alkalihydroxid-Lösung wurde die Menge an manganhaltigen Rückständen weiter reduziert, so daß keine merklichen derartigen Rückstände mehr auf der Oberfläche verbleiben und die Voraussetzungen für die Abscheidung einer im wesentlichen oder vollkommen Loch- und Fehlerfreien Metallschicht erfüllt sind. Die Behandlung mit der Alkalihydroxid-Lösung trägt auch zum Entfernen von Harzverschmierungen und harzhaltigen Rückständen sowie von Polyimidharzen bei.

Nachfolgend wird der erfindungsgemäße Gedanke anhand der Zeichnungen, die einige Ausführungsformen der vorliegenden Erfindung darstellen, näher erläutert.

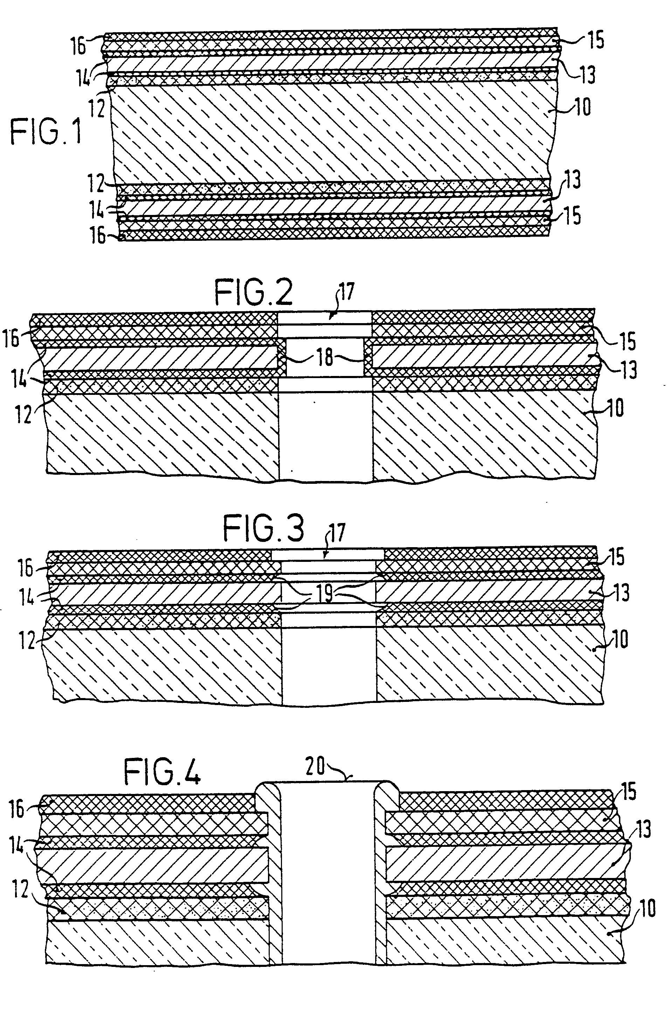

Die Zeichnungen haben nur beispielhaften Charakter ; die dort gezeigte Herstellung von leitenden Verbindungen durch Multiwire$^{RTM}$-Platten ist keineswegs das einzige Anwendungsgebiet für das Verfahren nach der vorliegenden Erfindung. Die Figuren 1 bis 4 stellen jeweils den gleichen Querschnitt durch eine Multiwire$^{RTM}$-Platte dar, allerdings in verschiedenen Stadien der Fertigung.

Fig. 2 zeigt den Zustand nach dem Bohren des Loches und des damit verbundenen Auftretens von Harzverschmierungen.

In Fig. 3 sind die Harzverschmierungen und die Isolierschicht vom an das Loch angrenzenden Teil des Leiterdrahtes entfernt.

In Fig. 4 ist das gleiche Loch nach der stromlosen Verkupferung dargestellt.

In Fig. 1 trägt eine Basismaterialplatte 10 aus Epoxyglasgewebe auf beiden Seiten eine Haftvermittlerschicht 12. Die Drähte des Schaltungsmusters 13 sind in den Haftvermittlerschichten 12 verlegt und mit einer Polyimidisolierung versehen (14). Zum Schutz der verlegten Drähte wird auf der Ober- und Unterseite je eine Folie aus Epoxyglasgewebe 15 mittels Hitze und Druck mit der Platte verpreßt. Ein mit einem druckempfindlichen Kleber aufgebrachter Polyäthylenfilm 16 stellt eine wieder entfernbare Maske während der anschließenden Metallabscheidung dar.

In Fig. 2 ist in die Multiwire$^{RTM}$-Platte ein Loch 17 gebohrt, das die Harzverschmierung 18 aufweist.

Fig. 3 stellt einen Schnitt durch die Platte dar, nachdem der Polyäthylenfilm 16 durch Wärmeeinwirkung so weit geschrumpft ist, daß der Rand des Loches 17 nicht mehr von diesem bedeckt wird. Es wurde auch bereits eine Behandlung mit einer alkalischen Permanganat-Lösung durchgeführt, um die Harzverschmierungen 18 zu beseitigen. Die manganhaltigen Rückstände auf der Oberfläche sowie die Polyimidisolierung 14 des Leiterdrahtes sind bei 19 durch Behandeln mit einer Alkalihydroxidlösung entfernt worden.

Aus Fig. 4 ist ersichtlich, daß zwischen dem auf der Lochwand abgeschiedenen Kupfer 20 und dem Draht 13 eine feste, weder durch Harzverschmierungen noch durch unbeschichtete Stellen beeinträchtigte Verbindung besteht.

Jedes beliebige Metallpermanganat kann verwendet werden, sofern es in wässrigen Lösungen stabil und zu mindestens 10 g/l löslich ist. Bevorzugt werden jedoch Alkali- und Erdalkalipermanganate, wobei die Verwendung von Natrium- und Kaliumpermanganat besonders vorteilhaft ist, da diese leicht und zu einem vergleichsweise niedrigen Preis zu beschaffen sind und gute Wasserlöslichkeit aufweisen. Der Permanganatgehalt der Lösung kann in weiten Grenzen, beispielsweise von 10 g/l bis zur Sättigungskonzentration variiert werden. Bei der Verwendung von Natrium- oder Kaliumpermanganat erweisen sich jedoch Konzentrationen zwischen 10 und 60 g/l als besonders geeignet, denn bis zu einem Wert von ungefähr 60 g/l steigt die Geschwindigkeit, mit der sich die Bindungszentren bilden, an. Wird die Konzentration über diesen Wert hinaus erhöht, so tritt keine Erhöhung der Geschwindigkeit mehr auf, während sich die Anlagerung manganhaltiger Rückstände auf der Substratoberfläche weiter verstärkt ; die vollständige Entfernung dieser Rückstände wird also erschwert. Bei Verwendung von geringeren Konzentrationen als 10 g/l bilden sich die Bindungszentren zu langsam aus, als daß derart niedrige Konzentrationen von produktionstechnischem Interesse sein könnten. Der pH-Wert der Permanganat-Lösung sinkt normalerweise im Laufe der Zeit durch $CO_2$-Aufnahme aus der Luft von beispielsweise 12,5 auf 11,5 ab, was eine Zugabe von KOH zur Lösung erforderlich macht. Zur Ermittlung der zum Einstellen der Lösung auf einen pH von 12,5 erforderlichen KOH-Menge dient eine genau bemessene Probe der Lösung, zu der so lange tropfenweise konzentrierte Kalilauge zugegeben wird, bis der gewünschte pH Wert erreicht ist. Nach dem KOH-Verbrauch zum Einstellen dieser Probe wird dann die für die Badlösung benötigte Menge an KOH errechnet.

Wahlweise können oxidationsunempfindliche Benetzer, wie beispielsweise fluorierte Kohlenwasserstoffe, der Lösung zugesetzt werden.

Die erforderliche Einwirkzeit und -temperatur bei diesem Verfahrensschritt schwankt ; grundsätzlich bewirkt eine Erhöhung der Temperatur die Aktivierung in kürzerer Zeit. Übliche Einwirkzeiten liegen im

Bereich von 5 Minuten bis zu über zwei Stunden bei Temperaturen zwischen 35 und 100 °C. Die besten Ergebnisse wurden bei Temperaturen zwischen 40 °C und 80 °C und Einwirkzeiten zwischen 5 und 75 Minuten erzielt. Die Behandlung kann im Tauch- oder Sprühverfahren erfolgen oder in einer anderen, für die Behandlung kunstharzhaltiger Oberflächen bekannten Art durchgeführt werden. Im Rahmen der vorliegenden Erfindung ist ein « Körper mit kunstharzhaltigen Oberflächen » ein solcher, der — z. B. in Formen gegossen, laminiert, kunstharzbeschichtet etc. — zur Gänze aus Kunstharz besteht oder wenigstens eine kunstharzhaltige Oberfläche aufweist.

Nach dem Verfahren nach der vorliegenden Erfindung können auch die in DE-PS-1 665 314 beschriebenen Basismaterialien, die eine Oberfläche mit einer kunstharzhaltigen Kleberschicht aufweisen, in die gleichmäßig feinverteilte Partikel von oxidierbarem und abbaubarem natürlichem oder künstlichem Kautschuk eingebettet sind, behandelt werden.

Sollen nach dem erfindungsgemäßen Verfahren verschiedene kunstharzhaltige Stoffe behandelt werden, so müssen die Mengenverhältnisse der Lösungsbestandteile so gewählt werden, daß das bestmögliche Ätzresultat erzielt wird. Zum Beispiel haben Harzverschmierungen, die beim Bohren von Löchern in Multiwire$^{RTM}$-Platten auftreten, keine einheitliche Zusammensetzung, da die Isolierschicht des Drahtes aus Polyimid besteht, während das laminierte Basismaterial beispielsweise aus einem Epoxyglaslaminat hergestellt sein kann ; die ebenfalls auf dem Basismaterial aufgebrachte harzhaltige Kleberschicht kann wiederum eine andere Zusammensetzung aufweisen. Es ist also durchaus möglich, daß die Harzverschmierung eine Mischung der drei genannten Komponenten sein kann.

Des weiteren sollen bei der Herstellung von Multiwire$^{RTM}$-Platten in diesem Verfahrensschritt nicht nur Harzverschmierungen von den Lochwandungen entfernt werden, sondern es soll auch die Polyimidisolierschicht gleichzeitig aus der direkten Umgebung der einen Teil der Lochinnenwand bildenden Drahtstirnflächen weggeätzt werden, um eine feste Verbindung zwischen abgeschiedenem Metall und den Drahtenden zu gewährleisten und die Ausbildung einer einfachen Berührungskontaktstelle zu vermeiden.

Die vorliegende Beschreibung schildert die Anwendung des erfindungsgemäßen Verfahrens anhand der Herstellung von Multiwire$^{RTM}$-Schaltungsplatten ; einem mit dem Sachgebiet vertrauten Fachmann wird es jedoch keine Schwierigkeiten bereiten, die beschriebenen Permanganat-Lösungen dem jeweiligen Anwendungsgebiet bzw. den jeweiligen kunstharzhaltigen Verbindungen anzupassen.

Die Entfernung von Harzrückständen und -verschmierungen sollte nach Möglichkeit innerhalb von 5-75 Min. erfolgen, wobei Einwirkzeiten zwischen 20 und 40 Minuten bevorzugt werden. Sollte eine längere Behandlung zur vollständigen Beseitigung von Harzrückständen erforderlich sein, so empfiehlt es sich, die Mehrebenen- oder Multiwire$^{RTM}$-Platte nach 20 bis 45 Minuten aus der Permanganatlösung zu entfernen, in die Neutralisierungslösung einzubringen, zu spülen und anschließend erneut in die permanganathaltige Lösung zu tauchen. Es wird angenommen, daß sich bei dieser Verfahrensweise weniger manganhaltige Rückstände bilden, die das Entfernen der Harzverschmierungen verlangsamen. Die Geschwindigkeit, mit der die Harzschicht entfernt wird, ist proportional der Permanganat-Konzentration, jedoch steigt auch die Menge der manganhaltigen Rückstände mit dieser an. Es werden daher Konzentrationen im Bereich von 45 bis 60 g/l Kaliumpermanganat bevorzugt.

Auch die Geschwindigkeit der Harzentfernung ist direkt proportional der Temperatur der Behandlungslösung, wobei Temperaturen zwischen 40 und 80 °C zufriedenstellende Ergebnisse liefern ; bevorzugt wird eine Temperatur von 60 °C. Werden Harzentfernungsbäder nach der vorliegenden Erfindung bei wesentlich niedrigeren Temperaturen als 40 °C betrieben, so verlangsamt sich die Entfernung der Harzverschmierungen erheblich und es treten Schwierigkeiten bei der Aufrechterhaltung der Permanganatkonzentration auf. Wesentlich höhere Temperaturen als 60 °C bieten keinen merklichen Vorteil, d. h. es tritt keine deutliche Erhöhung der Ätzgeschwindigkeit ein.

Ergebnisse werden erzielt, wenn der pH der alkalischen Permanganat-Lösung auf Werte zwischen 11 und 13 eingestellt ist, wobei sich ein pH von 12,5 als besonders vorteilhaft erwiesen hat. Zur Regulierung des pH Wertes wird vorzugsweise Natrium- oder Kaliumhydroxid verwendet.

Die Ergebnisse der Behandlung lassen sich verbessern, wenn der Lösung geringe Mengen eines Benetzers, z. B. eines fluorierten Kohlenwasserstoffes, zugesetzt werden ; bevorzugt wird beispielsweise ein Kaliumfluoroalkylcarboxylat, ein anionisches Tensid, verwendet.

Die erfindungsgemäße Verfahrensweise besteht darin, der Behandlung mit der Permanganat-Lösung die Behandlung mit einem Neutralisationsmittel folgen zu lassen, um vor der Katalysierung und Metallabscheidung auf der Oberfläche verbliebenes Permanganat zu neutralisieren. Dieser Neutralisationsschritt scheint die Entfernung überschüssigen Permanganats von harzhaltigen Oberflächen zu fördern und verhindert eine Verdünnung der in der Folge verwendeten Badlösungen sowie andere, störende, auf die Gegenwart eines starken Oxidationsmittels zurückzuführende Effekte bei den sich Anschließenden Verfahrensschritten.

Als Neutralisator eignen sich Zinn(II)-Ionen, wie sie beispielsweise in einer angesäuerten Zinn(II)-chloridlösung wie $SnCl_2 \cdot HCl$ vorliegen. Geeignet sind des weiteren Bisulfitionen, Hydroxylaminhydrochlorid, Salzsäure, Formaldehyd, Zucker sowie grundsätzlich jede wasserlösliche Verbindung, die durch Permanganat oxidiert werden kann.

Zum Neutralisieren wird der mit der Permanganat-Lösung behandelte Gegenstand kurz in eine wässrige Lösung getaucht, die das Neutralisationsmittel, beispielsweise in Konzentrationen zwischen 2

und 100 g/l, enthält, und anschließend gründlich mit Wasser gespült, bevor er dem nächsten Verfahrensschritt unterzogen wird. Weitere geeignete Neutralisatoren sind in DE-PS-2 550 597 beschrieben.

Das erfindungsgemäße Verfahren beinhaltet einen Ätzvorgang unter Verwendung einer heißen Lösung einer Base, meist eines Alkali- oder Tetraalkylammoniumhydroxids. Die Konzentration des verwendeten Hydroxids kann in weiten Grenzen, beispielsweise von 0,5 bis 20 mol/l variiert werden.

Die basische Lösung des jeweils verwendeten Hydroxids kann, wo dies wünschenswert erscheint, einen Komplexbildner für Mangan, beispielsweise Äthylendiaminotetraazetat (EDTA), ein Tartrat usw. enthalten. Des weiteren können der Lösung übliche Benetzer zugesetzt werden.

Die erforderliche Einwirkzeit ist von der Hydroxidkonzentration und der Temperatur der Behandlunglösung abhängig und kann beispielsweise zwischen 2 und 60 Minuten und vorzugsweise zwischen 10 und 30 Minuten liegen bei Temperaturen zwischen 40 und 95 °C. Als besonders wirkungsvoll zur Beseitigung manganhaltiger Rückstände hat sich eine Lösung von 19 mol/l Natriumhydroxid bei einer Temperatur von ca. 95 °C erwiesen. Da derartige Lösungen jedoch Schwierigkeiten in der Handhabung bereiten, werden niedrigere Temperaturen von ca. 60 °C und geringere Konzentrationen von ca. 4 mol/l bevorzugt. Im Anschluß an die Hydroxidbehandlung wird gründlich gespült.

Durch die zweistufige Ätzbehandlung mit einer Permanganat- und einer Hydroxid-Lösung bei einem pH von unter 13 erreicht man bei der Herstellung von Multiwire$^{RTM}$-Platten eine bessere Kontrollierbarkeit des Vorgangs als bei der Verwendung nur eines Ätzschritten bei einem pH von über 13.

Bei der Herstellung von Multiwire$^{RTM}$-Platten ist nicht nur die Entfernung von Harzverschmierungen und -rückständen aus den Bohrungen erforderlich, sondern es muß auch die Polyimidisolierung der Drähte an den durch das Durchtrennen der Drähte beim Bohren entstandenen Endstellen weggeätzt werden. Die Geschwindigkeit, mit der die Polyimidisolierung durch den Ätzvorgang entfernt wird, ist proportional der Hydroxidkonzentration der Permanganatlösung. Bei dem derzeit gebräuchlichen einstufigen Verfahren unter Verwendung einer Permanganatlösung mit hohem pH ist das Messen der Hydroxidkonzentration der Lösung mit einer pH-Elektrode oder durch einfache Titration schwierig und die Unmöglichkeit einer genauen Ermittlung des Hydroxidgehaltes der Lösung erschwert die Kontrolle der Polyimidätzung.

Bei der Verwendung des erfindungsgemäßen zweistufigen Permanganat-/Hydroxid-Ätzverfahrens mit niedrigerem pH erfolgt die Entfernung der Polyimidisolierung in einem gesonderten Ätzschritt mit einer Lösung, die kein Permanganat enthält und deren Hydroxidgehalt daher mittels einer einfachen Säure-Base-Titration bestimmt werden kann. Der verglichen mit dem einstufigen Verfahren niedrigere pH Wert der Permanganatlösung kann mit einer pH-Elektrode gemessen und hinreichend genau kontrolliert werden, um ihn bei ca. 12,5 zu halten.

Die Oberfläche eines harzhaltigen Materials kann für die stromlose Metallabscheidung aktiviert werden, indem das Material selbst einen Katalysator, beispielsweise eine Palladiumverbindung oder Kupferoxyd, enthält. Werden Werkstoffe verwendet, die keinen derartigen Zusatz als Katalysator enthalten, so muß sich, wie dem mit der stromlosen Metallabscheidung vertrauten Fachmann bekannt, an die erfindungsgemäßen Schritte zum Entfernen von Harzrückständen von den Lochwandungen, zur Förderung der Aktivität der Oberflächen die Behandlung mit einem Katalysator anschließen, um die voraktivierten Oberflächenfür die stromlose Metallabscheidung zu sensibilisieren, bevor diese in Kontakt mit dem Metallabscheidungsbad gebracht werden. Zur Oberflächensensibilisierung oder -katalysierung sind eine Reihe von Verfahren bekannt. Auf dem so aktivierten und — wenn nötig — mit einem Katalysator behandelten Körper wird sodann stromlos Metall abgeschieden, wie z. B. eine Nickelschicht aus einem bekannten Nickel-Hypophosphit-Bad. Statt Nickel kann auch Kupfer aus einem üblichen stromlos arbeitenden Verkupferungsbad auf der Oberfläche abgeschieden werden.

Das erfindungsgemäße Verfahren weist eine große Zahl von Vorteilen bezüglich der Steuerung der Verfahrensparameter auf. So ist es wegen des vergleichsweise niedrigen pH Wertes der Permanganat-Lösung möglich, diesen mit einer üblichen pH-Elektrode genau zu bestimmen und auf üblichem Wege konstant zu halten. Die Permanganatkonzentration kann spektralphotometrisch bei einer Wellenlänge von 525 nm oder durch eine potentiometrische Titration ermittelt werden.

Die Hydroxid-Lösung des erfindungsgemäßen zweiten Ätzschrittes kann mittels Säure-Base-Titration kontrolliert werden ; eine sehr genaue Überwachung der Hydroxidkonzentration ist dabei jedoch nicht erforderlich.

In den folgenden Beispielen werden Verfahren nach der vorliegenden Erfindung beschrieben. In allen Beispielen werden die Schaltungsplatten während sämtlicher Behandlungsschritte in chemischen Badlösungen senkrecht in einem Gestell befestigt, das ungefähr 15 bis 20 mal in der Minute um 5 bis 7,5 cm in horizontaler Richtung hin- und herbewegt wird.

## Beispiel 1

Multiwire$^{RTM}$-Platten wurden nach dem beschriebenen Verfahren hergestellt. Ein Glasfasergewebe wurde mit Epoxydharz, das katalytisches Füllmaterial enthält (DE-PS-1 696 604), imprägniert und auf beiden Seiten mit einer 0,1 mm dicken katalytisch aktivierbaren Kleberschicht versehen. Das so vorbehandelte Gewebe wurde auf ein 1,6 mm dickes, katalytisch aktivierbares Epoxyglaslaminat (FR-4$^{RTM}$) auflaminiert. Mit 0,15 mm starkem Kupferdraht mit einer Isolierschicht aus 0,013 mm dicken

Polyimid wurde auf der Kleberoberfläche das Leiterzugmuster hergestellt. Anschließend wurde auf das Verdrahtungsmuster mittels Druck und Temperatur ein Glasfasergewebe auflaminiert, das mit einem einen katalytischen Füllstoff enthaltenden Epoxyharz imprägniert ist. Anschließend wurden die Platten auf beiden Seiten mittels eines auf Druck reagierenden Klebers mit einem Polyäthylenfilm überzogen. Löcher mit einem Durchmesser von 1,17 mm, die die Drähte in eben jenen Punkten durchtrennen, in denen elektrisch leitende Verbindungen herzustellen sind, wurden angebracht.

Im nächsten Verfahrensschritt wurden Harzverschmierungen und -rückstände, die an den die Lochwandungen bildenden Schnittstellen der Drähte entstanden waren, durch Behandeln mit einer oxidierenden Permanganat-Lösung entfernt.

Im üblichen Produktionsverfahren folgt auf diesen Schritt die stromlose Verkupferung der Lochwandungen, wobei der oben erwähnte Polyäthylenfilm verhindert, daß sich Kupfer an den äußeren Oberflächen der Platten abscheidet. Im vorliegenden Beispiel wurden stattdessen die nach den entsprechenden Reinigungsschritten auf den Plattenoberflächen einschließlich den Lochwandungen verbleibenden manganhaltigen Rückstände mit Königswasser herausgelöst und dieses dann Atomabsorptionsspektrometrisch untersucht, wobei jeweils gleich große, z. B. 1 000 Löcher enthaltende Oberflächenbereiche behandelt wurden. Die für diese Untersuchungen verwendeten Platten wurden jeweils eine Stunde mit Permanganat-Lösungen behandelt, deren Zusammensetzung sich aus der nachstehenden Tabelle ergibt.

Alle Platten wurden zum Neutralisieren 5 Minuten in eine wässrige Lösung von 30 g/l Zinn(II)-chlorid und 300 ml/l Salzsäure eingebracht und anschließend mit Wasser gespült. Lediglich die Platten der Probe 5 wurden anschließend an das Spülen in eine Lösung von 19 mol/l NaOH bei 95 °C getaucht.

Die Auswirkungen der veränderten Bedingungen beim Permanganat/Hydroxid-Ätzvorgang sind in Tabelle I wiedergegeben :

Tabelle I

Atomabsorptions-Analyse

| Probe | Behandlungslösung* g/l | Mangangehalt pro 1000 Löcher (mg) | Mangangehalt pro Loch (µg) |
|---|---|---|---|
| 1. $KMnO_4$ | 60,0 | | |
| pH | 13,6 | | |
| Fluoroalkylcarboxylat | 0,2 | | |
| 60°C, 60 Min. | | | |
| 2. $KMnOH_4$ | 15,0 | 0,20 | 0,20 |
| pH | 13,6 | | |
| Fluoroalkylcarboxylat | 0,2 | | |
| 60°C, 60 Min. | | | |
| 3. $KMnO_4$ | 60,0 | 0,11 | 0,11 |
| pH | 12,5 | | |
| Fluoroalkylcarboxylat | 0,2 | | |
| 60°C, 60 Min. | | | |
| 4. $KMnO_4$ | 15,0 | 0,06 | 0,06 |
| pH | 12,5 | | |
| Fluoroalkylcarboxylat | 0,2 | | |
| 60°C, 60 Min. | | | |
| 5. a) $KMnO_4$ | 15,0 | | |
| pH | 12,6 | | |
| Fluoroalkylcarboxylat | 0,2 | | |
| 60°C, 60 Min. | | | |
| b) Neutralisieren u. Spülen | | nur in Spuren nachweisb | |
| 50% NaOH, 95°C, 20 Min. | | <0,01 | 0,01 |

* An die Permanganat-Behandlung schloß sich jeweils ein Neutralisations- und ein Spülvorgang an.

Dieses Beispiel zeigt deutlich, daß bei den vorbekannten Verfahren zur Lochreinigung bei pH 13,6 relativ große Mengen manganhaltiger Rückstände auf den Plattenoberflächen verbleiben, während bei der Lochreinigung nach dem Verfahren bei niedrigerem pH die Menge manganhaltiger Rückstände auf ein Drittel bis auf die Hälfte reduziert wird und bei der erfindungsgemäßen zusätzlichen Behandlung mit Alkalihydroxid nur noch kaum meßbare Spuren manganhaltiger Rückstände zurückbleiben.

Diese Ergebnisse erklären die bei der stromlosen Metallabscheidung gemachten Erfahrungen : je größer die Menge manganhaltiger Rückstände auf den Oberflächen, desto größere Schwierigkeiten treten bei der stromlosen Verkupferung auf. Es konnte gezeigt werden, daß ein Zusammenhang zwischen dem Auftreten von Löchern in der abgeschiedenen Metallschicht sowie der ungewöhnlich langen Zeit bis zum Einsetzen der Metallabscheidung bei der Fertigung von Multiwire RTM-Platten und der Menge der auf dem Epoxyglassubstrat verbleibenden manganhaltigen Rückstände besteht.

Auch bei der Herstellung konventioneller Mehrebenen-Schaltungsplatten treten Löcher in der stromlos abgeschiedenen Metallschicht auf, selbst wenn im Anschluß an die übliche Behandlung mit einer Permanganat-Lösung bei hohem pH mit einem Palladium-haltigen Katalysator aktiviert wurde.

Es wird vermutet, daß sich bei der Verwendung von Permanganat-Lösungen mit hohem pH (13,6) zur Reinigung der Löcher Bindungen zwischen dem Mangan und dem Harz auf der Lochwandoberfläche ausbilden :

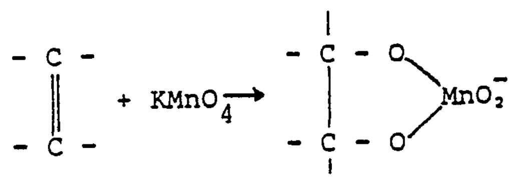

Das an der Harzoberfläche gebundene Mangan scheint dann, nach einem noch unbekannten Mechanismus, die stromlose Kupferabscheidung an den Lochwandungen zu beeinträchtigen, gleichgültig, ob es sich, wie bei der Herstellung von Mehrebenenschaltungen, um ein übliches katalytisches Aktivierungsverfahren mit einer Pd-haltigen Aktivierungslösung oder, wie beim Multiwire[RTM]-Verfahren, um ein Volladditiv-Verfahren, bei dem das Pd im Epoxyharz fein verteilt vorliegt, handelt. Wenn Platten mit manganhaltigen Rückständen in ein ohne äußere Stromquelle arbeitendes Verkupferungsbad eingebracht werden, wird dieses instabil und es bilden sich metallische Kupferpartikel in der Lösung, statt nur an den Lochwandungen. Die Ursache für diese Instabilität könnte eine Mangan-katalysierte Konkurrenzreaktion zur Abscheidungsreaktion an den Lochwandungen sein :

| Normale Reaktion an den Lochwandungen: | Mangan-katalysierte Konkurrenzreaktion: |
|---|---|
| $Cu^{+2} \longrightarrow Cu^{0}$ | $Cu^{+2} \longrightarrow Cu^{+1}$ |
| Lochwand | $2Cu^{+1} \longrightarrow Cu^{0} + Cu^{+2}$ |

Die Geschwindigkeit dieser Mangan-katalysierten Konkurrenzreaktion steigt mit zunehmender Badaktivität und es ist folglich nicht möglich, die Aktivität des Kupferabscheidungsbades durch Erhöung des Formaldehydgehaltes und des pH zu steigern, um das Auftreten von Löchern in der abgeschiedenen Metallschicht zu vermeiden, da dies in Gegenwart manganhaltiger Rückstände zu einer erhöhten Instabilität der Badlösung führt.

## Beispiel 2

Das in Beispiel 1 beschriebene Verfahren wurde wiederholt, wobei jedoch nur eine Lösung zur Lochreinigung eingesetzt wurde, die 60 g/l Kaliumpermanganat und 0,2 g/l eines Fluoroalkylcarboxylats enthielt und in der die Platten 30 Minuten verblieben. Nach der Neutralisation und dem Spülen wurde die eine Platte — im Gegensatz zur anderen — in eine Lösung aus 19 mol/l NaOH bei 95 °C eingebracht. Beide Platten wurden anschließend mit Königswasser zum Entfernen der Manganrückstände behandelt. Die beiden so erhaltenen Lösungen wurden auf ihren Mangangehalt untersucht ; die Lösung der Platte, die nicht mit der NaOH-Lösung behandelt worden war, wies 0,10 mg Mangan auf, während die Lösung der Platte, die der Behandlung mit NaOH unterzogen worden war, nur einen Mangangehalt von 0,04 mg aufwies.

## Beispiel 3

Dieses Beispiel beschreibt die Anwendung des erfindungsgemäßen Verfahrens für die Herstellung von Mehrebenenschaltungen.

Ober- und Unterseite der Platte bestanden aus 35 µm starker Kupferfolie. Im Innern der Platte trennten Epoxydglasgewebeschichten von zwischen 100 und 150 µm sechs Ebenen mit Leiterbahnen aus 35 µm dickem Kupfer voneinander.

Derartige Schaltungsplatten werden mittels üblicher Laminierungsverfahren hergestellt und weisen durchgehende Bohrungen mit einem Durchmesser von ca. 1 mm auf.

Mikroskopische Untersuchungen von Schnitten durch eine Reihe solcher Bohrungen zeigen durch den Bohrvorgang verursachte Harzverschmierungen und -rückstände auf den Lochwandungen einschließlich den durch Kupferschichten gebildeten Bereichen derselben.

Zum Entfernen der Harzverschmierungen und -rückstände und zur Metallabscheidung wurden die mit Löchern versehenen Mehrebenen-Schaltungsplatten wie folgt behandelt :

1. Die Platten werden für 20 Min. in eine auf 65 °C temperierte Lösung der folgenden Zusammensetzung eingebracht :

| | |
|---|---|
| Kaliumpermanganat | 45 g/l |
| Fluoroalkylcarboxylat | 0,4 ml/l |

sowie NaOH in ausreichender Menge, um den pH auf 12,8 einzustellen.

2. Eintauchen für 3 Min. in ein Neutralisationsbad, das 20 g/l Natriumbisulfit und eine ausreichende Menge Schwefelsäure zum Einstellen des pH auf 4,5 enthält, bei Raumtemperatur.

3. Ein zweiter Neutralisationsschritt wie in 2. für 3 Min.

4. Spülen unter fließendem Wasser für 5 Min.

5. Eintauchen für 20 Min. in eine auf 60 °C temperierte Lösung folgender Zusammensetzung :

| | |
|---|---|
| NaOH | 150 g/l |
| Benetzer (Paranonylphenoxypolyglycidol) | 1 g/l |

6. Spülen unter fließendem Wasser für 5 Minuten.

7. Ausheizen zum Entfernen der Feuchtigkeit in einem Ofen bei 120 °C über einen Zeitraum von 1 Stunde.

8. Eintauchen in eine bekannte wässrige Vorbehandlungslösung für 6 Min. bei 60 °C. Diese Lösung enthält eine Mischung von kationischen und anionischen oberflächenaktiven Substanzen und ein Alkanolamin bei einem pH von 2.

9. Spülen unter fließendem Wasser für 5 Minuten.

10. Einbringen in eine milde Kupferätzlösung bei Raumtemperatur für eine Minute ; die Lösung enthält 60 g/l Natriumpersulfat und eine ausreichende Menge Schwefelsäure, um den pH auf 2,5 einzustellen.

11. Spülen unter fließendem Wasser für 5 Minuten.

12. Eintauchen in eine Entoxidierungslösung aus 900 ml/l Wasser und 100 ml/l Schwefelsäure bei Raumtemperatur für 1 Minute.

13. Spülen unter fließendem Wasser für 5 Minuten.

14. Eintauchen in eine angesäuerte Lösung von Zinnchlorid in einer Kochsalzsole bei Raumtemperatur für 3 Minuten.

15. Eintauchen in eine Palladium-Zinn-Chloridlösung bei 45 °C für 10 Minuten. Diese Katalysatorlösung besteht aus 30 ml einer Lösung entsprechend Beispiel 1 von DE-PS 24 34 638 und 970 ml einer 20 %igen Kochsalzlösung.

16. Spülen unter fließendem Wasser für 5 Minuten.

17. Eintauchen in eine wässrige Fluorborsäurelösung bei Raumtemperatur für 2 Minuten.

18. Spülen unter fließendem Wasser für 5 Minuten.

19. Eintauchen für 30 Minuten in ein stromlos arbeitendes Verkupferungsbad der folgenden Zusammensetzung :

| | |
|---|---|
| Äthylendiamintetra-2-propanol | 17 g/l |
| Kupfersulfat-Pentahydrat | 9 g/l |
| Formaldehyd (37 %) | 20 ml/l |
| NaOH | 22 g/l |
| NaCN | 0,01 g/l |
| Kaliumbisulfit | 0,8 mg/l |
| 2-Mercaptobenzothiazol | 0,08 mg/l |
| ein Blockcopolymer aus Äthylenoxid und Propylenoxid | 0,001 g/l |

Bei den Verfahrensschritten 1, 2, 3, 5, 8, 10, 12, 15, 17 und 19 werden die Platten wie beschrieben, bewegt.

Aus dem stromlos arbeitenden Metallabscheidungsbad entsprechend Beispiel 3 wurde auf den Lochwandungen und auf der Kupferoberfläche der Platten eine 2 µm dicke Kupferschicht abgeschieden. Nach dem Spülen und Trocknen wurde die Kupferschicht auf den Lochwandungen nach bekannten

Verfahren galvanisch bis zu einer Gesamtschichtdicke von 30 bis 35 µm verstärkt. Die Kupferfolien auf der Ober- und Unterseite der Platten wurden mit einer gebräuchlichen Abdeckmaske versehen und die Leiterzugbahnen durch Ätzen des freiliegenden Kupfers hergestellt.

Die so hergestellte Mehrebenen-Schaltungsplatte wies glatte Lochwandungen ohne Epoxydrückstände oder Harzverschmierungen auf dem Kupfer der innen Schaltungsebenen auf ; das abgeschiedene Kupfer bildete eine ununterbrochene, lückenlose Schicht. Die Haftung zwischen stromlos abgeschiedenem Kupfer und Folienkupfer war ausgezeichnet.

### Beispiel 4

Dieses Beispiel zeigt die Anwendung des erfindungsgemäßen Verfahrens bei der Herstellung einer Mehrebenen-Schaltungsplatte aus glasfaserverstärktem Polyimid mit Ober- und Unterseiten aus je 35 µm dicker Kupferfolie und sechs inneren Leiterzugebenen aus je 35 µm dickem Kupfer, die durch glasfaserverstärktes Polyimid in einer Schichtdicke von 100 bis 150 µm voneinander getrennt sind. Zwischen den Schichten aus glasfaserverstärktem Polyimid und dem Kupfer befindet sich jeweils eine sehr dünne Schicht aus Akrylharz, die die Haftung zwischen den Polyimid- und den Kupferschichten gewährleistet.

Löcher mit einem Durchmesser von ungefähr 1 mm wurden durch die Mehrebenen-Schaltungsplatte gebohrt. Mikroskopische Untersuchungen der Lochwandungen zeigten Rückstände auf den Kupferschichten, die vermutlich aus dem Akrylharzkleber oder aus diesem und dem Polyimid bestanden. Die Platte wurde, wie in Beispiel 3 beschrieben, gereinigt und mit Metall beschichtet.

Die so hergestellte Mehrebenen-Schaltungsplatte hatte glatte Lochwandungen, die frei von Rückständen waren und keinerlei Lücken in der Metallbeschichtung oder unbeschichtete Bereiche aufwiesen. Die Haftung zwischen der abgeschiedenen Kupferschicht und dem Folienkupfer war ausgezeichnet.

### Beispiel 5

Dieses Beispiel zeigt, daß bei der Herstellung von Mehrebenen-Schaltungsplatten aus Epoxidglasgewebe als Basismaterial die erfindungsgemäße Behandlung mit Alkali zum Entfernen der manganhaltigen Rückstände von den Lochwandungen erforderlich ist.

Eine erste Gruppe von Mehrebenen-Schaltungsplatten aus Epoxidglasgewebe mit einer Ober- und Unterseite aus Kupferfolie und zwei inneren Kupferschichten mit durch Ätzen hergestellten Leitermustern wurde, wie in Beispiel 3 beschrieben, gereinigt und mit Kupfer beschichtet. Jede der Kupferschichten hatte eine Stärke von 35 µm und wurde durch 450 µm dicke Schichten aus Epoxidglasgewebe voneinander getrennt. Die Lochwandungen der so behandelten Mehrebenen-Schaltungsplatten wiesen keinerlei Epoxidrückstände oder -verschmierungen oder unbeschichtete Bereiche auf ; die Haftfestigkeit zwischen abgeschiedenem Kupfer und Folienkupfer war ausgezeichnet.

Eine zweite Gruppe von Mehrebenen-Schaltungsplatten wie oben beschrieben wurde ebenfalls, wie in Beispiel 3 beschrieben, behandelt, jedoch wurden die Verfahrensschritte 5 und 6 weggelassen. Eine beträchtliche Anzahl der Lochwandungen wies kleine Bereiche auf, die nicht mit Metall beschichtet waren, obgleich keine Epoxidrückstände oder -verschmierungen festgestellt werden konnten und die Haftung zwischen abgeschiedenem und Folienkupfer ausgezeichnet war. Platten mit den festgestellten Fehlern müßten in der gewerblichen Fertigung einem erneuten Kupferabscheidungsvorgang unterzogen werden, um die unbeschichteten Bereiche zu verkupfern.

Dieses Ergebnis bestätigt die Notwendigkeit einer Alkalibehandlung im Rahmen des beschriebenen erfindungsgemäßen Verfahrens.

### Beispiel 6

Dieses Beispiel beschreibt den Zusatz eines Komplexbildners zur Alkalihydroxid-Lösung.

Multiwire$^{RTM}$-Platten wurden, wie in Beispiel 1 beschrieben, hergestellt. Die Lochreinigung wurde wie folgt durchgeführt :

1. Eintauchen in eine wässrige Lösung von 60 g/l Kaliumpermanganat und 0,2 g/l Fluoroalkylcarboxylat bei einem pH von 12,5 und 60 °C für 1 Stunde.
2. Eintauchen in eine Neutralisationslösung, die 30 g/l Zinn (II) chlorid enthält, wie in Beispiel 1 beschrieben, für 3 Minuten.
3. Eintauchen in eine Neutralisationslösung, die 3 g/l Zinn(II) chlorid enthält, für 3 Minuten.
4. Spülen unter fließendem Wasser für 5 Minuten.
5. Eintauchen in eine Lösung der folgenden Zusammensetzung für 30 Minuten bei 45 °C :

| | |
|---|---|
| Natrium-Kaliumtartrat | 100 g/l |
| Natriumhydroxid | 120 g/l |
| Fluoroalkylcarboxylat | 0,2 g/l |
| Äthylenoxidpolymer | 2 mg/l |

6. Spülen unter fließendem Wasser für 5 Minuten.

7. Einbringen in ein ohne äußere Stromzufuhr arbeitendes Kupferabscheidungsbad folgender Zusammensetzung :

| | |
|---|---|
| Kupfersulfat | 0,04 mol/l |
| Äthylendiamintetra-2-propanol (Komplexbildner) | 0,06 mol/l |
| Formaldehyd | 0,07 mol/l |
| Natriumcyanid (Stabilisator) | 0,006 mol/l |
| Schwefel (Stabilisator) | 3 µmol/l |
| Phosphorsäureester (Benetzer) | 0,15 mg/l |
| Äthylenoxidpolymer | 1,0 mg/l |
| Temperatur | 62 °C |
| pH | 12,7 |

Nach 8 Stunden hatte sich eine einheitliche Kupferschicht von 50 µm Dicke an den Lochwandungen abgeschieden, die fest an den Drahtenden haftete.

Beispiel 7

Dieses Beispiel zeigt die Anwendung des erfindungsgemäßen Verfahrens bei der Herstellung einer Mehrebenen-Schaltungsplatte mit vier Leiterzugebenen.

Die Ober- und Unterseite der Platte sowie die zwei inneren Ebenen bestehen aus Kupfer und sind durch Schichten eines Epoxidglasgewebes voneinander getrennt. In die Platte wurden Löcher gebohrt, deren Wandungen Harzverschmierungen aufwiesen. Für die Metallabscheidung wurden folgende Verfahrensschritte durchgeführt :

1. Eintauchen in eine Lösung aus 60 g/l $KMnO_4$ und einer ausreichenden Menge NaOH, um den pH auf 12,5 einzustellen, bei 60 °C für eine Stunde.

2. Eintauchen in eine Neutralisationslösung aus 30 g/l $SnCl_2 \cdot 2H_2O$ und 300 ml/l konz HCl (37 %) bei 20 bis 25 °C.

3. Spülen unter fließendem Wasser für 5 Minuten.

4. Eintauchen für 20 Minuten in eine 60 °C heiße Lösung, die 150 g/l NaOH enthält.

5. Spülen unter fließendem Wasser für 5 Minuten.

6. Entoxidieren für 3 Min. in einer Lösung, die 180 g/l $H_2SO_4$ enthält.

7. Spülen unter fließendem Wasser für 1 Minute bei 20 bis 25 °C.

8. Eintauchen für 10 Min. in eine Sensibilisierungslösung aus 1 g/l Palladiumchlorid, 60 g/l Zinn(II) chlorid, und 100 g/l konz. HCl (37 %) (in Form des in DE-AS 14 46 224 beschriebenen Palladiumchlorid-Zinn(II) chlorid-Komplexes).

9. Spülen in Wasser.

10. Einbringen in ein stromlos Kupfer abscheidendes Bad (entsprechend Beispiel 7 US-PS 3 672 986) bei einer Temperatur von 55 °C für einen Zeitraum von 50 Stunden ; es wird eine Kupferschicht von 25 µm abgeschieden.

11. Trocknen der Platte an der Luft.

Die Leiterzugmuster auf den Außenseiten der Platten wurden im herkömmlichen Druck- und Ätzverfahren hergestellt. Die Haftung zwischen dem stromlos an den Lochwandungen abgeschiedenen Kupfer und dem Kupfer der vier Leiterzugebenen war gut und die stromlos abgeschiedene Kupferschicht wies keine Unterbrechungen auf.

Selbstverständlich kann die Ober- und Unterseite der Platte statt mit Kupferfolie mit einer Kleberschicht versehen sein, wie in DE-PS 16 65 314 beschrieben, und das Leiterzugmuster nach dem Additiv-Verfahren hergestellt werden. In diesem Fall kann die Platte im Anschluß an den Verfahrensschritt 9 getrocknet und mit einer Resistmaske versehen werden. Es ist dann kein Ätzvorgang erforderlich, um die Leiterzugmuster auf den Außenseiten der Platte herzustellen.

Nach einem anderen, in DE-PS 16 96 604 beschriebenen Additiv-Verfahren können das Epoxidglasmaterial und die Kleberschicht an den Plattenoberflächen bereits einen Katalysator enthalten, so daß der oben beschriebene Schritt 8 entfällt. Die stromlose Metallabscheidung erfolgt dann direkt im Anschluß an das Aufbringen der Resistmaske.

Beispiel 8

Die im Beispiel 7 beschriebenen Verfahrensschritte werden wiederholt, wobei jedoch die Schritte 1 und 4 wie folgt geändert werden :

— im Schritt 1 : $KMnO_4$ 0,5 mol/l
— im Schritt 4 : NaOH 20 mol/l

bei Temperaturen von 90 °C und einer Behandlungsdauer von 20 Minuten.

Die stromlos abgeschiedenen Kupferschichten waren lückenlos und wiesen eine ausgezeichnete Haftung auf dem Kupfer der inneren Schaltungsebenen auf.

Beispiel 9

Das im Beispiel 6 beschriebene Verfahren wird wiederholt, wobei jedoch die Schritte 2 und 3 durch die folgenden ersetzt wurden :

— Spülen in stehendem Wasser für 1 Minute

— Einbringen in eine Lösung aus 50 g/l Hydroxylamin-Hydrochlorid und 20 ml/l konz. HCl (37 %).

Außerdem wurde im Schritt 5 kein Natrium-Kaliumtartrat verwendet.

Beispiel 10

Das im Beispiel 7 beschriebene Verfahren wird wiederholt, wobei im Schritt 4 das Natriumhydroxid durch 150 g/l KOH ersetzt wurde.

Die hergestellten Metallschichten wiesen die gleiche Güte auf wie die nach dem unveränderten Beispiel 7 hergestellten.

Beispiel 11

Dieses Beispiel beschreibt die Verwendung einer weiteren Neutralisationslösung bei der Durchführung des im Beispiel 7 beschriebenen Verfahrens, wobei anstelle des Schrittes 2 die folgende Behandlung tritt :

— Eintauchen für 5 Minuten in eine Lösung mit einem pH von 4,5 aus 30 g/l $NaHSO_3$ bei 20 bis 25 °C.

Beispiel 12

Es wird wie in Beispiel 7 verfahren bis auf den Schritt 4 : stattdessen wurde die Platte für 20 Min. in eine 60 °C heiße Lösung aus 150 g/l LiOH eingebracht. Die erzielten Ergebnisse entsprachen denjenigen, die bei der Durchführung des unveränderten Beispiels 7 erzielt wurden.

Beispiel 13

Die im Beispiel 7 beschriebenen Verfahrensschritte wurden wiederholt, wobei jedoch im Schritt 1 die Platte für 1 Stunde in eine 60 °C heiße Lösung aus 60 g/l $NaMnO_4$ und einer ausreichenden Menge NaOH, um den pH auf 12,5 einzustellen, getaucht wurde.

Auch hier wurden Ergebnisse erzielt, die denen bei Durchführung des unveränderten Beispiels 7 entsprachen.

Beispiel 14

Es wurde, wie in Beispiel 6 beschrieben, verfahren, wobei jedoch anstelle des Schrittes 5 die Platte für 40 Min. bei 60 °C in eine 10 %ige Lösung von Tetramethylammoniumhydroxid getaucht wurde.

Die Ergebnisse entsprachen denen des unverändert durchgeführten Beispiels 6.

Beispiel 15

Das im Beispiel 7 beschriebene Verfahren wurde wiederholt, wobei jedoch anstelle des dort beschriebenen Schrittes 1 wie folgt verfahren wurde :

— Eintauchen für eine Stunde in eine Lösung von 60 °C, die 60 g/l $KMnO_4$, 40 g/l $K_2CO_3$ und eine ausreichende Menge KOH zum Einstellen des pH auf 12,5 enthielt.

Die Ergebnisse entsprachen denen des unverändert durchgeführten Beispiels 7.

**Patentansprüche**

1. Verfahren zur Vorbereitung der kunstharzhaltigen Oberfläche eines Werkstückes für die nachfolgende Metallisierung vermittels der folgenden Verfahrensschritte :

— Behandeln der Oberfläche mit einer alkalischen Permanganat-Lösung deren pH auf einen Wert zwischen 11 und 13 eingestellt ist für eine Zeitspanne, die ausreicht, um eine für eine auf der genannten Oberfläche abzuscheidende Metallschicht ausreichende Haftfestigkeit zu gewährleisten ;

— Behandeln der Oberfläche mit einer Lösung einer durch Permanganat oxidierbaren wasserlöslichen Verbindung für eine Zeitspanne, die ausreicht, um alle Manganrückstände zu reduzieren und sie in eine niedrige Oxidationstufe zu überführen, dadurch gekennzeichnet, daß anschließend die Oberfläche mit einer alkalischen Lösung bei einer Temperatur zwischen 30 °C und 95 °C und für eine Zeitspanne, die

ausreicht, um alle Manganrückstände zu entfernen, behandelt wird.

2. Verfahren nach Anspruch 1, dadurch gekennzeichnet, daß der pH der Permanganat-Lösung auf einen Wert zwischen 12 und 13 eingestellt wird.

3. Verfahren nach Anspruch 1, dadurch gekennzeichnet, daß für die alkalische Lösung entweder ein Alkalimetallhydroxid oder ein Tetraalkylammoniumhydroxid verwendet wird.

4. Verfahren nach Anspruch 3, dadurch gekennzeichnet, daß die Hydroxid-Konzentration zwischen 0,5 und 20 mol/l beträgt.

5. Verfahren nach Anspruch 4, dadurch gekennzeichnet, daß die Hydroxid-Konzentration zwischen 1 und 10 mol/l beträgt.

6. Verfahren nach Anspruch 5, dadurch gekennzeichnet, daß die Hydroxid-Konzentration zwischen 2 und 4 mol/l beträgt.

7. Verfahren nach Anspruch 1, dadurch gekennzeichnet, daß vor der Behandlung mit der alkalischen Lösung ein Spülschritt erfolgt.

8. Verfahren nach Anspruch 1, dadurch gekennzeichnet, daß nach der Behandlung mit der alkalischen Lösung ebenfalls ein Spülschritt erfolgt.

9. Verfahren nach Anspruch 1, dadurch gekennzeichnet, daß die Behandlung mit der alkalischen Lösung zwischen 2 und 60 Minuten dauert.

10. Verfahren nach Anspruch 1 zur Vorbereitung der kunstharzhaltigen Oberflächen und/oder Lochwandungen von Mehrebenenschaltungen mit mindestens drei Schichten, von denen die innenliegende(n) aus Isolierstoff besteht (bestehen) und wenigstens einen metallischen Leiterzug aufweist (aufweisen) sowie mindestens ein durch alle Schichten reichendes Loch, dadurch gekennzeichnet, daß die Oberflächen und/oder Lochwandungen mit der alkalischen Lösung bei einer Temperatur zwischen 40 und 95 °C behandelt werden.

11. Verfahren nach Anspruch 1 zur Vorbereitung der kunstharzhaltigen Oberflächen und/oder Lochwandungen von automatisch verlegten Drahtschaltungen mit wenigstens einem mit einer Polyimid-Isolierung versehenen Drahtleiter, der auf der Oberfläche befestigt oder in diese eingebettet ist, und wenigstens einem Loch, das den Draht durchtrennt und das wenigstens einen Teil der Unterlage durchdringt, so daß die Stirnflächen des durchtrennten Drahtes einen Teil der Lochinnenwand bilden, und daß dieser Teil der Lochinnenwand durch die beim Bohren entstehenden Harzverschmierungen verunreinigt ist, dadurch gekennzeichnet, daß die Oberfläche und/oder die Lochinnenwandungen mit der alkalischen Lösung bei einer Temperatur zwischen 40 °C und 95 °C behandelt wird (werden) ; wobei gleichzeitig die aus Polyimid bestehende Drahtisolierung an den einen Teil der Lochinnenwand bildenden durchtrennten Drahtenden entfernt wird, so daß eine saubere, metallische Drahtanschlußfläche für den Kontakt mit der Lochwandmetallisierung entsteht.

## Claims

1. Method for the preparation of the synthetic-resin containing surface of a workpiece for the metallization following thereof by means of the following procedural steps :

— Treatment of the surface with an alkaline permanganate solution the pH of which is adjusted to a value between 11 and 13 for a period of time which is sufficient to guarantee a metal layer of sufficient adhesive strength to be precipitated thereon ;

— Treatment of such surface with a solution of a watersoluble compound oxidizable by means of permanganate for a period of time which is sufficient for reducing all manganese residues and to transform them into a lower stage of oxidation, characterized in that subsequently said surface is treated with an alkaline solution at a temperature between 30 °C and 95 °C and for a period of time which is sufficient to remove all manganese residues.

2. Method according to Claim 1, characterized in that the pH of the permanganate solution is adjusted to a value between 12 and 13.

3. Method according to Claim 1, characterized in that either an alkaline metal hydroxide or a tetraalkyl ammonium hydroxide is used for said alkaline solution.

4. Method according to Claim 3, characterized in that the hydroxide concentration amounts to between 0.5 and 20 mol/l.

5. Method according to Claim 4, characterized in that the hydroxide concentration amounts to between 1 and 10 mol/l.

6. Method according to Claim 5, characterized in that the hydroxide concentration amounts to between 2 and 4 mol/l.

7. Method according to Claim 1, characterized in that a rinsing step is carried out prior to the treatment with the alkaline solution.

8. Method according to Claim 1, characterized in that another rinsing step is carried out after the treatment with the alkaline solution.

9. Method according to Claim 1, characterized in that the treatment with the alkaline solution lasts between 2 and 60 minutes.

10. Method according to Claim 1 for the preparation of the synthetic-resin containing surfaces and/or

hole walls of multi-level circuits with at least three layers the innermost of which consists (consist) of insulating material and is (are) provided with at least one conductor strip and at least one hole extending through all layers, characterized in that the surfaces and/or hole walls are treated with the said alkaline solution at a temperature of between 40 °C and 95 °C.

11. Method according to Claim 1 for the preparation of synthetic-resin containing surfaces and/or hole walls of automatically placed wire circuits with at least one wire conductor provided with a polyimide insulation which is fastened to said surface or is embedded into same, and at least one hole, which severs said wire and which penetrates at least part of the substrate, so that the front faces of the severed wire form part of the inner hole wall, and that part of said inner hole wall is contaminated by resin smears produced during drilling, characterized in that the surface and/or said inner hole walls is (are) treated with the said alkaline solution at a temperature of between 40 °C and 95 °C, at the same time the wire insulation consisting of polyimide being removed from the severed wire ends forming part of the inner hole wall, so that a clean, metallic wire connection face is produced for the contact with the hole wall metallization.

**Revendications**

1. Procédé pour la préparation de la surface d'une pièce d'œuvre contenant de la résine synthétique en vue de sa métallisation subséquente au moyen des étapes du procédé suivantes :

— traitement de la surface par une solution de permanganate alcaline dont le pH est ajusté sur une valeur entre 11 et 13 pendant une période suffisante en vue de garantir une force d'adhérence suffisante pour une couche métallique à être précipitée sur la surface susmentionnée ;

— traitement de la surface susmentionnée par une solution d'un composé soluble dans l'eau et oxydable par le permanganate pendant une période suffisante pour réduire tous les résidus de manganèse et de les transformer en un degré d'oxydation plus bas, caractérisé par le fait qu'ensuite la surface est traitée par une solution alcaline à une température entre 30 °C et 95 °C et pendant une période suffisante pour enlever tous les résidus de manganèse.

2. Procédé selon la revendication 1, caractérisé par le fait que le pH de la solution de permanganate est ajusté sur une valeur entre 12 et 13.

3. Procédé selon la revendication 1, caractérisé par le fait qu'on utilise soit un hydroxyde d'un métal alcalin soit un hydroxyde d'ammonium tétraalcoylé pour en préparer la solution alcaline.

4. Procédé selon la revendication 3, caractérisé par le fait que la concentration de l'hydroxyde se situe entre 0,5 et 20 mol/l.

5. Procédé selon la revendication 4, caractérisé par le fait que la concentration de l'hydroxyde se situe entre 1 et 10 mol/l.

6. Procédé selon la revendication 5, caractérisé par le fait que la concentration de l'hydroxyde se situe entre 2 et 4 mol/l.

7. Procédé selon la revendication 1, caractérisé par le fait qu'une étape de lavage précède le traitement par la solution alcaline.

8. Procédé selon la revendication 1, caractérisé par le fait qu'une étape de lavage suit le traitement par la solution alcaline.

9. Procédé selon la revendication 1, caractérisé par le fait que le traitement par la solution alcaline dure entre 2 et 60 minutes.

10. Procédé selon la revendication 1 pour la préparation des surfaces contenant de la résine synthétique et/ou des parois de trous de circuits à niveaux multiples à au moins trois couches dont l'intérieure (les intérieures) est (sont) composée(s) d'une matière isolante et présente(nt) au moins un trait de conducteur ainsi qu'au moins un trou pénétrant toutes les couches, caractérisé par le fait que les surfaces et/ou les parois du trou sont traitées par la solution alcaline à une température entre 40 °C et 95 °C.

11. Procédé selon la revendication 1 pour la préparation des surfaces contenant de la résine synthétique et/ou des parois de trou appartenant à des circuits de fil placés automatiquement contenant au moins un fil conducteur muni d'une isolation en polyimide étant attaché sur la surface ou en étant encastré, et au moins d'un trou coupant le fil et pénétrant au moins partie de la sous-couche tel que les faces frontales du fil coupé forment une partie de la paroi intérieure du trou, et que cette partie de la paroi intérieure du trou est souillée par les encrassements en résine se produisant par le forage du trou, caractérisé par le fait que la surface et/ou les parois intérieures du trou sont traitées par la solution alcaline à une température entre 40 °C et 95 °C, l'isolation du fil en polyimide étant enlevée, en même temps, des bouts du fil coupé formant une partie de la paroi intérieure du trou pour en produire une surface de connexion de fil nette et métallique pour le contact par la métallisation de la paroi du trou.

FIG.1

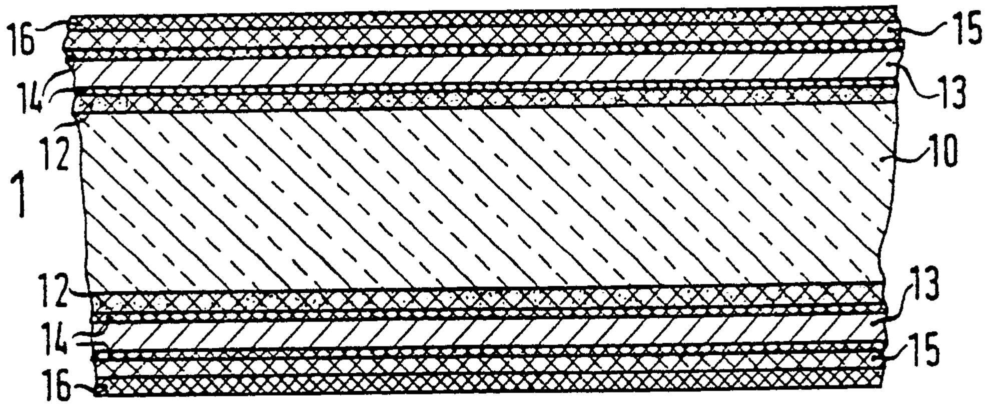


FIG.2

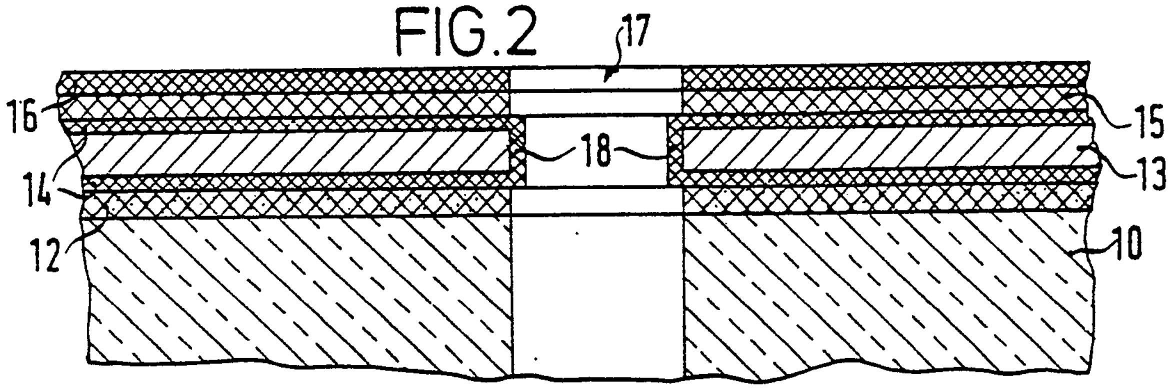


FIG.3

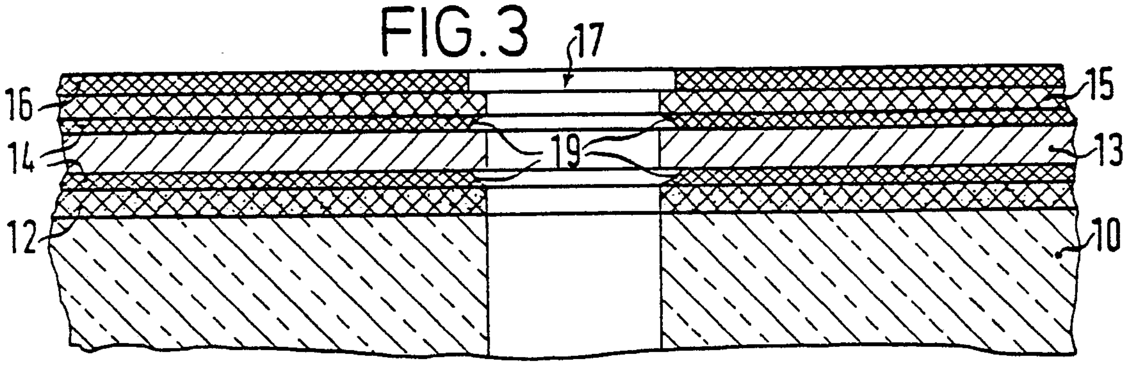


FIG.4